# EUROPÄISCHE PATENTANMELDUNG

(11) **EP 4 451 322 A1**
(43) Veröffentlichungstag der Anmeldung: **23.10.2024**
(21) Anmeldenummer: 24170509.4
(22) Anmeldetag: 16.04.2024
(51) Int. Cl.: H01L 21/8252, H01L 27/06, H01L 27/085, H01L 29/20, H01L 29/778, H01L 29/78, H01L 29/808

(54) **HOCHLEISTUNGSBAUELEMENT AUF BASIS VON III-NITRID-VERBINDUNGSHALBLEITERN, ZWISCHENERZEUGNIS UND VERFAHREN ZUR HERSTELLUNG EINES HOCHLEISTUNGSBAUELEMENTES**

(30) Priorität: 17.04.2023 DE 102023109595
(71) Anmelder: Fraunhofer-Gesellschaft zur Förderung der angewandten Forschung e.V., 80686 München (DE)
(72) Erfinder: Döring, Philipp, 79108 Freiburg (DE); Reiner, Richard, 79108 Freiburg (DE)
(74) Vertreter: LBP Lemcke, Brommer & Partner Patentanwälte mbB

(57) **Zusammenfassung**

Die Erfindung betrifft ein Hochleistungsbauelement (1) auf Basis von III-Nitrid-Verbindungshalbleitern, umfassend zumindest ein erstes, vertikales Transistor-Bauelement (2) und zumindest ein zweites Bauelement (10) mit einer lateralen Heterostruktur (11), wobei die laterale Heterostruktur (11) des zweiten Bauelements (10) auf einem Teilbereich (4) einer Oberfläche (3) des ersten, vertikalen Bauelementes (2) monolithisch mittels selektivem epitaktischem Überwachsens ausgebildet ist, wobei das zweite Bauelement (10) zumindest einen Transistor und optional weitere aktive und/oder passive Bauelemente umfasst, und wobei sowohl das erste Transistor-Bauelement (2) als auch das zweite Bauele-ment (10) auf Basis von III-Nitrid-Verbindungshalbleitern gebildet sind. Weiter betrifft die Erfindung ein Zwischenerzeugnis (16) zur Herstellung eines Hochleistungsbauelementes (1) sowie ein Verfahren zur Herstellung eines Hochleistungsbauelementes (1) auf Basis von III-Nitrid-Verbindungshalbleitern.

## Beschreibung

Die Erfindung betrifft ein Hochleistungsbauelement auf Basis von III-Nitrid-Verbindungshalbleitern nach Anspruch 1 sowie ein Zwischenerzeugnis zur Herstellung eines Hochleistungsbauelementes nach Anspruch 10. Weiter betrifft die Erfindung auch ein Verfahren zur Herstellung eines Hochleistungsbauelementes auf Basis von III-Nitrid-Verbindungshalbleitern nach Anspruch 11.

Bauteile auf Basis von III-Nitrid-Verbindungshalbleitern weisen ein großes Potenzial im Bereich von Hochleistungs-Schaltanwendungen auf Grund ihrer besonderen physikalischen Eigenschaften gegenüber Technologien basierend auf Silizium oder Siliziumcarbid auf. Insbesondere sind Transistoren mit hoher Elektronenbeweglichkeit, sogenannte HEMT, auf Basis von III-Nitrid-Verbindungshalbleitern bereits seit einigen Jahren kommerziell erhältlich und werden insbesondere im Bereich der Hochfrequenz- oder Leistungselektronik eingesetzt.

So ist es beispielsweise aus der Veröffentlichung "A study on the Performance of AIGaN/GaN HEMTs Regrown on Mg-Implanted GaN Layers with low channel Thickness (Döring et al, IEEE Transaction on Electron Devices, DOI 10.1109/TED.2023.3237803,) die Herstellung von AIGaN/GaN Transistoren mit hoher Elektronenbeweglichkeit bekannt, wobei in einem ersten Schritt Galliumnitrid auf einem Siliziumsubstrat hergestellt und danach einer Magnesium-Implantation zur p-Typ Dotierung unterzogen wird. Anschließend erfolgt in einem Nach-Wachstum, dem sogenannten Re-Growth, die Ausbildung der Heterostrukturen, insbesondere einer sogenannten HEMT-Struktur für besonders schnell schaltende Transistoren auf dem mit Magnesium implantierten Substrat. Damit wird beispielsweise die Herstellung von großflächigen HEMT-Strukturen auf großflächigen Wafern als Ausgangspunkt zur Herstellung weiterer Transistor-Bauelemente ermöglicht.

Weiter ist es bekannt großflächige CAVETs mit co-integrierten HEMTs auf Basis von Galliumnitrid herzustellen, wobei auch hier zunächst eine großflächige Galliumnitrid-Schicht erzeugt und anschließend mit Magnesium zur Erzeugung einer dünnen p-Typ dotierten Schicht implantiert wird, wobei anschließend die AlGaN/GaN Heterostruktur des CAVETs auf dem so bearbeitenden Substrat durch Nach-Wachstum erzeugt wird. (Technology of GaN-Based Large Area Cavets with Co-Integrated HEMTs, IEEE Transaction on Electron Devices, VOL. 68, No. 11, November 2021, Döring et al).

Während somit laterale Hochleistungstransistoren auf Basis der Gallium-Nitrid Technologie bereits bekannt und am Markt erhältlich sind, wurde die Herstellung von vertikalen Bauelementen auf Basis der III-Nitrid-Verbindungshalbleiter noch wenig untersucht. Dies mag insbesondere daran liegen, dass es an nativen Nitrid-Substraten mangelt und somit insbesondere auf andere Substrate wie beispielsweise Siliziumcarbid (SiC) oder Silizium (Si) zurückgegriffen werden muss.

Insbesondere die Integration von vertikalen Bauelementen mit lateralen Bauelementen bietet vielfältige Möglichkeiten in der Steuerung, insbesondere auf dem Gebiet der energie-effizienten Leistungselektronik und hier vor allem im Bereich von zukunftsrelevanten Technologien wie der Elektromobilität, der Photovoltaik oder der Windkraft. Hierzu ist es im Stand der Technik bekannt, vertikale Bauelemente und laterale Bauelemente durch Wafer-Bonding oder hybride Integrationsverfahren miteinander in Kontakt zu bringen und zu verbinden. Der Aufwand hierfür und entsprechend auch die Kosten sind hierfür sehr hoch. Zudem weisen die Bauteile durch diese Art der Aufbautechniken große Ausmaße auf, deren Einsatz aufgrund ihrer Größe und ihres Gewichtes nicht in allen technologischen Bereichen möglich ist. Weiterhin kann die Zuverlässigkeit im Betrieb z. B. aufgrund nicht-kompatibler thermischer Ausdehnungskoeffizienten beeinträchtigt werden.

Im Bereich der vertikalen Bauelemente wird verstärkt auf die genannte GaN-on-Si-Technologie gesetzt, bei welcher vertikale Galliumnitrid-Bauelemente auf Silizium-Substraten hergestellt werden, wobei im Anschluss an die Fertigstellung des Bauelementes das Silizium-Substrat entfernt wird. Nachteilig hierbei ist, dass die Qualität des Galliumnitrids aufgrund des Silizium-Substrates gegenüber der Verwendung anderer Substrate wie beispielsweise Saphir oder SiC deutlich schlechter ist. Andererseits sind Silizium-Substrate kostengünstig und in großflächigen Formaten erhältlich, womit eine entsprechend wirtschaftliche Herstellung ermöglicht wird.

Zudem ist es weiter im Stand der Technik bekannt eine Leuchtdiode auf Basis von Galliumnitrid auf einem Metalloxid-Halbleiter-Feldeffekttransistor, einem sogenannten MOSFET, herzustellen, wie dies in der Veröffentlichung "Monolithic integration of GaN-based light-emitting diodes and metal-oxide semiconductor field-effect transistors", Lee et. al., Optics Express A1589, 2014, beschrieben ist. Hierbei werden jedoch die entsprechenden Strukturen zunächst vollflächig auf das Substrat aufgebracht und anschließend mittels selektiven Ätzens einzelne Bereiche herausgearbeitet, um die entsprechende MOSFET-Struktur mit monolithisch integrierter Leuchtdiode zu erzielen.

Es ist Aufgabe der vorliegenden Anmeldung ein Hochleistungsbauelement, ein Zwischenerzeugnis sowie ein Verfahren zur Herstellung eines Hochleistungsbauelementes anzugeben, mittels welchem die Herstellung eines Bauelementes mit hoher Sperrfestigkeit ermöglicht wird.

Zudem ist es eine Aufgabe ein Hochleistungsbauelement, ein Zwischenerzeugnis sowie ein Verfahren zur Herstellung eines Hochleistungsbauelementes anzugeben, mittels welchem laterale und vertikale Transistor-Bauelemente in einfacher Weise miteinander integriert werden können.

Diese und weitere Aufgaben werden gelöst durch ein Hochleistungsbauelement gemäß Anspruch 1, ein Zwischenerzeugnis zur Herstellung eines Hochleistungsbauelementes gemäß Anspruch 16 sowie durch ein Verfahren zur Herstellung eines Hochleistungsbauelementes gemäß Anspruch 17.

Vorteilhafte Ausgestaltungsformen des Hochleistungsbauelementes sind in den Ansprüchen 2 bis 9 dargelegt. Weitere vorteilhafte Ausführungsformen des Verfahrens zur Herstellung eines Hochleistungsbauelementes sind in den Ansprüchen 12 bis 15 dargelegt.

Insbesondere ist das Hochleistungsbauelement nach einem Verfahren zur Herstellung eines Hochleistungsbauelementes oder einer vorteilhaften Ausführungsform hiervon hergestellt. Des Weiteren führt auch die Durchführung des Verfahrens zur Herstellung eines Hochleistungsbauelementes oder einer vorteilhaften Ausführungsform hiervon zu einem erfindungsgemäßen Hochleistungsbauelement oder einer vorteilhaften Ausführungsform hiervon.

Als eine erste Lösung wird ein Hochleistungsbauelement auf Basis von III-Nitrid-Verbindungshalbleitern angegeben, welches zumindest ein erstes, vertikales Transistor-Bauelement und zumindest ein zweites Bauelement mit einer lateralen Heterostruktur umfasst, wobei die laterale Heterostruktur des zweiten Bauelementes auf einem Teilbereich einer Oberfläche des vertikalen Bauelementes monolithisch mittels selektiven epitaktischen Überwachsens ausgebildet ist, wobei das zweite Bauelement zumindest einen Transistor und optional zumindest ein weiteres aktives und/oder passives Bauelement umfasst.

Das zumindest eine zweite Bauelement wird somit nur auf einer Teilfläche des ersten vertikalen Transistor-Bauelementes ausgebildet, wodurch gerade kein vollflächiges Überwachstum des ersten vertikalen Transistor-Bauelementes, wie dies beispielsweise bei CAVETS erfolgt, erfolgt. Hierbei ist insbesondere von Vorteil, dass sowohl das vertikale Transistor-Bauelement als auch das laterale Bauelement monolithisch ausgebildet sind, wobei eine Teilfläche der Oberfläche des ersten vertikalen Transistor-Bauelementes als Substrat zur Ausbildung des zweiten Bauelementes mit lateraler Heterostruktur dient. Insbesondere kann bei dem erfindungsgemäßen Hochleistungsbauelement auf ein Wafer-Bonding von vertikalem Transistor-Bauelement und lateralem Bauelement, welches neben zumindest einem Transistor optional auch zumindest ein aktives und/oder passives Bauelement umfassen kann, verzichtet werden, wobei auch die Qualität des Bauelementes, insbesondere durch die Reduktion unerwünschter parasitärer Einflüsse der Aufbautechnik beim Bonding, verbessert wird. Insgesamt werden durch die monolithische Integration die parasitären, kapazitiven und induktiven Effekte, insbesondere beim zweiten Bauelement reduziert. Zudem wird eine höhere energetische Effizienz und eine hinsichtlich der Produktionskosten höhere Flächeneffizienz erzielt, da die erfindungsgemäßen Hochleistungsbauelemente deutlich kleiner ausgebildet werden können. Hierdurch sind diese bevorzugt einsetzbar auf dem Gebiet der energie-effizienten Leistungselektronik z. B. aber nicht ausschließlich im Bereich der Elektromobilität, der Photovoltaik oder in Windkraftanlagen. Schließlich können mit dem erfindungsgemäßen Hochleistungsbauelement hohe Stromtragfähigkeiten und niedrige Schichtwiderstände erzielt werden, wodurch das erfindungsgemäße Hochleistungsbauelement eine weitaus höhere Effizienz und Leistungsdichte gegenüber der gewöhnlichen lateralen GaN-Technologie aufweist.

Durch das selektive Überwachsen wird die laterale Heterostruktur des zweiten Bauelementes nur auf dem Teilbereich ausgebildet, wobei die Oberfläche außerhalb des Teilbereiches frei von der lateralen Heteorstruktur und/oder weiteren Bauelementen ist.

Mit III oder auch Gruppe-III bezeichnet sind im Allgemeinen die Elemente der dritten Hauptgruppe des Periodensystems gemeint. Insbesondere handelt es sich hierbei um die Elemente Aluminium (Al), Gallium (Ga) und/oder Indium (In). Zusätzlich können auch Scandium (Sc) und/oder Yttrium (Y) in den Schichtstrukturen der Bauelemente umfasst sein. Bei den III-Nitrid-Verbindungshalbleitern handelt es sich um Halbleiter auf Basis der Gruppe-III-Nitride. Insbesondere handelt es sich hierbei um binäre, ternäre, quaternäre oder quinternäre Verbindungshalbleiter wie beispielsweise Gallium-Nitrid (GaN), Aluminium-Gallium-Nitrid (AlGaN) oder Indium-Aluminium-Gallium-Nitrid (InAIGaN).

Bei dem das zweite Bauelement optional umfassenden aktiven Bauelement kann es sich beispielsweise um eine oder mehrere Dioden und/oder einen oder mehrere Sensoren handeln. Bei dem das zweite Bauelement optional umfassenden passiven Bauelement kann es sich beispielsweise um einen oder mehrere Kondensatoren, Widerstände, Induktivitäten und/oder Sensoren handeln. Beispielsweise kann es sich bei dem Sensor um einen temperatursensitiven Sensor handeln. Auch Kombinationen der vorgenannten aktiven und/oder passiven Bauelemente können neben dem zumindest einen Transistor in dem zweiten Bauelement umfasst sein.

Insbesondere kann das zweite Bauelement eine integrierte Schaltung darstellen.

Vorzugsweise ist das zweite Bauelement als ein Transistor ausgebildet.

Optional kann auch das erste Transistor-Bauelement zumindest ein weiteres aktives und/oder passives Bauelement umfassen.

In einer bevorzugten Ausführungsform sind sowohl das erste Transistor-Bauelement als auch das zweite -Bauelement auf Basis von III-Nitrid-Verbindungshalbleitern gebildet. Damit basieren sowohl das erste Transistor-Bauelement als auch das zweite Bauelement auf III-Nitrid-Verbindungshalbleitern, wodurch Bauelemente mit einer hohen Sperrfestigkeit erzielt und die physikalischen und technischen Vorteile der III-Nitrid-Technologie, wie beispielsweise eine direkte Bandlücke der Verbindungshalbleiter, für das erste Transistor-Bauelement und das zweite Bauelement genutzt werden können.

Eine bevorzugte Ausführungsform des Hochleistungsbauelementes zeichnet aus, dass innerhalb der lateralen Heterostruktur des zweiten Bauelementes ein zweidimensionales Elektronengas ausgebildet ist. Die laterale Heterostruktur des zweiten Bauelementes wird somit so erzeugt, dass innerhalb derer sich ein zweidimensionales Elektronengas ausbildet, welches eine sehr genaue und zuverlässige Steuerung des zweiten Bauelementes auch bei Frequenzen im Bereich von 1 Hz bis 100 GHz, bevorzugt im Bereich von 50 Hz bis 10 GHz ermöglicht.

Eine weitere bevorzugte Ausführungsform des Hochleistungsbauelementes zeichnet aus, dass eine Schaltgeschwindigkeit des ersten Transistor-Bauelementes im Bereich von 0,1 V/ns bis 1000 V/ns, bevorzugt im Bereich von 1 V/ns bis 100 V/ns liegt.

In einer vorteilhaften Ausführungsform ist die laterale Heterostruktur auf Basis von AlGaN, AIN, ScAlGaN, InAIGaN und/oder YAlGaN ausgebildet. Die vorgenannten Materialien eignen sich besonders zur Herstellung einer lateralen Heterostruktur für ein hochwertiges zweites Bauelement, wodurch eine gute Steuerung und Zuverlässigkeit des zweiten Bauelementes in der Anwendung erzielt werden kann.

In einer besonders bevorzugten Ausführungsform ist zur Ausbildung des Teilbereichs auf der Oberfläche des ersten Transistor-Bauelementes eine Schutzschicht außerhalb des Teilbereiches ausgebildet. Die Schutzschicht dient somit zur Ausbildung des Teilbereiches, welcher frei von einer Schutzschicht ist und auf welchem das zweite Bauelement nach Ausbilden der Schutzschicht erstellt wird. Bevorzugt kann es sich bei der Schutzschicht um eine hochtemperaturstabile Schutzschicht handeln. Durch die Verwendung einer hochtemperaturstabilen Schutzschicht bleibt diese auch beim Überwachsen zur Erzeugung des zweiten Bauelementes erhalten und kann danach selektiv entfernt werden. Insbesondere ist die Schutzschicht selektiv auf der Oberfläche des ersten Transistor-Bauelementes aufgebracht, wohingegen der Teilbereich frei von einer Schutzschicht ist.

In einer besonders bevorzugten Ausführungsform ist die Schutzschicht aus einem Dielektrikum gebildet, insbesondere aus Siliziumnitrid oder Siliziumoxid. Ein Dielektrikum lässt sich einerseits leicht auf die Oberfläche des ersten Transistor-Bauelementes aufbringen und entsprechend leicht auch mittels selektiven Ätzens, beispielsweise mittel KOH, von der Oberfläche nach dem Überwachsen und monolithischen Ausbilden des zweiten Bauelementes entfernen, ohne dass hierbei die III-Nitrid-Verbindungshalbleiter angegriffen oder beeinflusst werden.

Eine vorteilhafte Ausführungsform zeichnet aus, dass das Hochleistungsbauelement eine Sperrfestigkeit größer 200 V, bevorzugt größer 600 V, besonders bevorzugt größer 1 kV aufweist. Eine hohe Sperrfestigkeit kann insbesondere durch die entsprechende laterale Heterostruktur des zweiten Bauelementes erzielt werden. Hierdurch wird insgesamt die Betriebssicherheit des Hochleistungsbauelementes erhöht, wodurch dieses bevorzugt im Bereich der Hochvolt-Anwendungen, wie z. B. der Elektromobilität, der Photovoltaik oder von Windkraftanlagen einsetzbar ist.

In vorteilhafterweise ist das erste Transistor-Bauelement frei von einem polarisationsinduzierten Elektronenkanal, wodurch aufgrund der Umsetzbarkeit, ein verbesserter flächenspezifischer Widerstand erreicht werden kann.

In einer weiter bevorzugten Ausführungsform umfasst das erste Transistor-Bauelement mehrere Schichten, wobei vorzugsweise die die Oberfläche bildende oberste Schicht des ersten Transistor-Bauelementes n-typ dotiert oder p-typ dotiert ist. Eine dotierte Schicht als oberste, die Oberfläche bildende Schicht des ersten Transistor-Bauelementes dient insbesondere als Substrat für das zweite Bauelement. Die dotierte Schicht ermöglicht entsprechende elektrische Schaltungsmöglichkeiten und erlaubt somit eine Einflussnahme des zweiten Bauelementes auf das erste Transistor-Bauelement. Über die oberste dotierte Schicht kann somit in Abhängigkeit der Ausgestaltung des zweiten Bauelementes das erste Transistor-Bauelement entsprechend beeinflusst und gesteuert werden.

Alternativ oder vorzugsweise ergänzend ist auf den Teilbereich zwischen dem ersten Transistor-Bauelement der lateralen Heterostruktur des zweiten Bauelementes eine Diffusionssperre ausgebildet. Durch die Diffusionssperre wird insbesondere verhindert, dass Dotierstoffe in die laterale Heterostruktur des zweiten Bauelementes hinein diffundieren beim Überwachsen und Ausbilden der lateralen Heterostruktur bzw. des zweiten Bauelementes. Insbesondere hat die Dotierung einen speziellen Einfluss auf die Ausbildung der Bauelemente und deren Funktion, sodass eine Vermeidung von Diffusion erzielt werden sollte. Als Diffusionssperre wird insbesondere das Material AIN oder AlGaN verwendet.

Eine vorteilhafte Ausführungsform des Hochleistungsbauelementes zeichnet aus, dass ein Source-Kontakt des zumindest einen Transistors des zweiten Bauelementes in das erste Bauelement, insbesondere in die oberste Schicht des ersten Transistor-Bauelementes hineinragend ausgebildet wird. Somit können Kontakte des zweiten Bauelementes auch zur Steuerung und Beeinflussung des ersten Transistor-Bauelementes eingesetzt werden.

In einer bevorzugten Ausführungsform ist das erste Bauelemente als ein MOSFET, Trench MOSFET, DMOS, JFET, FinFET, OGFET oder SIT ausgebildet. Das erste, vertikale Transistor-Bauelement kann somit vielfältige Formen des Transistors darstellen, wobei das zweite Bauelement auf dem ersten Transistor-Bauelement unabhängig von der Wahl oder Ausgestaltung des ersten Transistor-Bauelementes auf der Oberfläche durch Überwachstum monolithisch hergestellt wird.

In vorteilhafter Weise ist das zweite Bauelement als ein HEMT ausgebildet oder umfasst zumindest einen HEMT. Vorzugsweise ist das zweite Bauelement als ein MOSHEMT oder MISHEMT ausgebildet oder umfasst zumindest eine entsprechendes Element. HEMT-Strukturen haben den Vorteil, dass diese eine hohe Sperrfestigkeit aufweisen und gleichzeitig schon im Bereich der Hochfrequenz- oder Leistungselektronik in vielfältiger Weise eingesetzt werden.

Alternativ oder vorzugsweise ergänzend umfasst das zweite Bauelement ein p-Gate, insbesondere ein p-GaN-Gate oder Recess-Gate um eine sicherheitstechnisch vorteilhafte Normally-off Variante erzeugen zu können bei der ohne Gate-Spannung kein Strom fließt.

In einer nochmals weiteren bevorzugten Ausführungsform wird das zweite Bauelement als Kaskaden-Schaltung für das erste Bauelement verwendet. Hierdurch können insbesondere Verstärkungsschaltungen realisiert werden. Insbesondere weist das erste Transistor-Bauelement ein selbstleitendes Verhalten und das zweite Bauelement ein selbstsperrendes Verhalten auf. Das so ausgestaltete Hochleistungsbauelement weist dann insgesamt ein selbstsperrendes Verhalten und findet insbesondere Anwendung als Normally-Off Kaskade.

Alternativ oder vorzugsweise ergänzend wird das zweite Bauelemente als integrierter Gate-Treiber, Stromsensor und/oder Temperatursensor für das erste Transistor-Bauelement verwendet. Das zweite Bauelement kann somit in vielfältiger Weise, in Abhängigkeit der lateralen Heterostruktur und seiner genauen Ausgestaltung, verwendet werden und insbesondere zur Schaltung oder als Sensor für das erste Transistor-Bauelement genutzt werden.

Als eine weitere Lösung der Aufgabe wird ein Zwischenerzeugnis zur Herstellung eines Hochleistungsbauelement wie vorstehend dargelegt oder einer bevorzugten Ausführungsform hiervon angegeben, wobei das Zwischenerzeugnis zumindest ein erstes, vertikales Transistor-Bauelement und eine mittels Epitaxie monolithisch ausgebildete laterale Heterostruktur auf einem Teilbereich einer Oberfläche des ersten, vertikalen Bauelementes sowie außerhalb des Teilbereiches der Oberfläche des ersten, vertikalen Bauelementes eine Schutzschicht, insbesondere eine hochtemperaturstabile Schutzschicht umfasst. Dieses Zwischenerzeugnis kann anschließend prozessiert werden, indem beispielsweise die Schutzschicht entfernt wird und die laterale Heterostruktur durch Ausbilden von Kontakten zu dem zweiten Bauelement weiterverarbeitet wird.

Als eine nochmals weitere Lösung der Aufgabe wird ein Verfahren zur Herstellung eines Hochleistungsbauelementes auf Basis von III-Nitrid-Verbindungshalbleitern angegeben, umfassend die Schritte:
A) Bereitstellen eines Substrates;
B) Herstellen zumindest eines ersten, vertikalen Transistor-Bauelementes auf dem Substrat mittels Epitaxie;
C) Selektives Beschichten einer Oberfläche des ersten Bauelementes mit einer Schutzschicht bis auf einen Teilbereich;
D) Herstellen einer monolithischen lateralen Heterostruktur auf dem Teilbereich durch Überwachsen mittels Epitaxie;
E) Ätzen der Schutzschicht; und
F) Prozessieren der Heterostruktur zur Ausbildung zumindest eines zweiten Bauelementes mit lateraler Heterostruktur auf dem Teilbereich des ersten Bauelementes, wobei das zweite Bauelement zumindest einen Transistor und optional zumindest ein weiteres aktives und/oder passives Bauelement umfasst.

Durch das erfindungsgemäße Verfahren wird ein monolithisch ausgebildetes Hochleistungsbauelement erzeugt, bei welchem zumindest ein vertikales Transistor-Bauelement und zumindest ein weiteres, zweites Bauelement mit lateraler Heterostruktur, umfassend zumindest einen Transistor und optional zumindest ein weiteres aktives und/oder passives Bauelement, gemeinsam ausgebildet sind, wodurch auf ein Wafer-Bonding bzw. eine hybride Aufbautechnik verzichtet werden kann. Dadurch wird ein Hochleistungsbauelement mit hoher Qualität erzielt, wobei durch die monolithische Integration die parasitären, kapazitiven und induktiven Effekte, insbesondere beim zweiten Bauelement reduziert werden. Zudem wird eine höhere Effizienz und eine höhere Flächeneffizienz erzielt, da nach dem erfindungsgemäßen Verfahren nur ein Teilbereich der Oberfläche des ersten Transistor-Bauelementes für das zweite Bauelement verwendet wird und die Bauelemente durch die monolithische Integration insgesamt kleiner ausgebildet werden können. Schließlich können die nach dem Verfahren hergestellten Hochleistungsbauelemente hohe Stromtragfähigkeiten und niedrige Schichtwiderstände aufweisen, wodurch das erfindungsgemäße Hochleistungsbauelement eine weitaus höhere Effizienz und Leistungsdichte gegenüber der gewöhnlichen lateralen GaN-Technologie aufweist.

Insbesondere erfolgen die Verfahrensschritte in der Reihenfolge A) bis F) nacheinander.

Vorzugsweise erfolgt das selektive Beschichten der Oberfläche in Verfahrensschritt C) mit einer Maske, so dass der Teilbereich frei von einer Schutzschicht ausgebildet wird. Alternativ oder vorzugsweise ergänzend wird die Schutzschicht in Verfahrensschritt C) vollflächig aufgebracht und die Schutzschicht auf dem Teilbereich durch selektives Ätzen, insbesondere mittels einer Maske, entfernt.

Das zumindest eine erste Transistor-Bauelement kann nach Verfahrensschritt B) bereits vollständig prozessiert sein, so dass alle wesentlichen Komponenten des Transistor-Bauelementes bereits vorhanden sind, beispielsweise auch die Kontakte für Source, Drain und Gate. Bevorzugt liegt das erste Transistor-Bauelement nach Verfahrensschritt B) in einer Form vor, in welcher das erste Transistor-Bauelement bereits strukturell vollständig prozessiert ist und lediglich die Kontakte noch nicht vollständig ausgebildet sind. Vorzugsweise erfolgt das Ausbilden und Fertigstellen des ersten Transistor-Bauelementes, insbesondere das Ausbilden der Kontakte im Zuge des Prozessierens der Heterostruktur zum zweiten Bauelement in Verfahrensschritt F).

Eine bevorzugte Ausführungsform des Verfahrens zeichnet aus, dass das erste Bauelement als ein MOSFET, Trench MOSFET, DMOS, JFET, FinFET, OGFET oder SIT ausgebildet wird. Das erste, vertikale Transistor-Bauelement kann somit vielfältige Formen des Transistors darstellen, wobei das zweite Bauelement auf dem ersten Transistor-Bauelement unabhängig von der Wahl oder Ausgestaltung des ersten Transistor-Bauelementes auf der Oberfläche durch Überwachstum monolithisch hergestellt wird. Insbesondere handel es sich bei einem OGFET um einen oxidbasierten vertikalen Trench MOSFET mit einer undotierten GaN-Zwischenschicht als Kanal.

Alternativ oder vorzugsweise ergänzend wird das zweite Bauelement als ein HEMT oder einen HEMT umfassend ausgebildet. Besonders bevorzugt wird das zweite Bauelement als ein MOSHEMT oder MISHEMT oder eine entsprechendes Element umfasend ausgebildet. HEMT-Strukturen haben den Vorteil, dass diese eine hohe Sperrfestigkeit aufweisen und gleichzeitig schon im Bereich der Hochfrequenz- oder Leistungselektronik in vielfältiger Weise eingesetzt werden. Alternativ und insbesondere bevorzugt wird das zweite Bauelement ein p-Gate, insbesondere p-GaN-Gate, oder Recess-Gate umfassend ausgebildet.

In einer vorteilhaften Ausführungsform wird nach dem Verfahrensschritt C) und vor dem Verfahrensschritt D) auf den Teilbereich eine Diffusionssperre aufgebracht. Durch die Diffusionssperre wird insbesondere verhindert, dass Dotierstoffe in die laterale Heterostruktur des zweiten Bauelementes hinein diffundieren beim Überwachsen und Ausbilden der lateralen Heterostruktur bzw. des zweiten Bauelementes.

Eine bevorzugte Ausführungsform zeichnet aus, dass als Substrat Saphir, Silizium, SiC, GaN oder eine Keramik verwendet wird. Insbesondere Silizium ist kostengünstig in großflächigen Formaten verfügbar. Die Verwendung von Saphir, SiC oder GaN ermöglicht die Ausbildung hochwertiger Schichten auf Basis der III-Nitrid-Verbindungshalbleiter, wobei jedoch gerade GaN Substrate sehr teuer und nur in kleinen Formaten verfügbar sind.

In vorteilhafter Weise erfolgt der Verfahrensschritt F) vor dem Verfahrensschritt E). Das Prozessieren der Heterostruktur zur Ausbildung eines zweiten Bauelementes kann somit noch vor dem Ätzen der Schutzschicht erfolgen, wodurch die Oberfläche des ersten Transistor-Bauelementes während des Prozessierens weiter geschützt ist.

Alternativ oder vorzugsweise ergänzend liegt nach dem Verfahrensschritt D) oder nach dem Verfahrensschritt E) ein Zwischenerzeugnis vor. Das Zwischenerzeugnis umfasst somit bevorzugt das zumindest eine erste vertikale Transistor-Bauelement sowie die laterale Heterostruktur für das zweite Bauelement.

In einer bevorzugten Ausführungsform erfolgt die Epitaxie mittels Metallorganischer Chemischer Gasphasenabscheidung (MOCVD) oder Molekularstrahlepitaxie (MBE). Hierdurch lassen sich hochwertige Hochleistungsbauelemente mit hochwertigen Schichten und somit geringer Beeinflussung durch Defekte in der Kristallstruktur erzielen.

Weitere vorteilhafte Merkmale und Ausgestaltungen werden im Folgenden anhand von Ausführungsbeispielen und den Figuren erläutert. Dabei zeigen:
- Figuren 1a) bis 1c): verschiedene Zeitpunkte im Zuge des Verfahrens zur Herstellung eines Hochleistungsbauelementes;
- Figur 2: eine Ausführungsform eines erfindungsgemäßen Hochleistungsbauelements;
- Figur 3: eine weitere Ausführungsform eines erfindungsgemäßen Hochleistungsbauelements;
- Figur 4: eine nochmals weitere Ausführungsform eines erfindungsgemäßen Hochleistungsbauelements; und
- Figur 5: eine nochmals weitere Ausführungsform eines erfindungsgemäßen Hochleistungsbauelements.

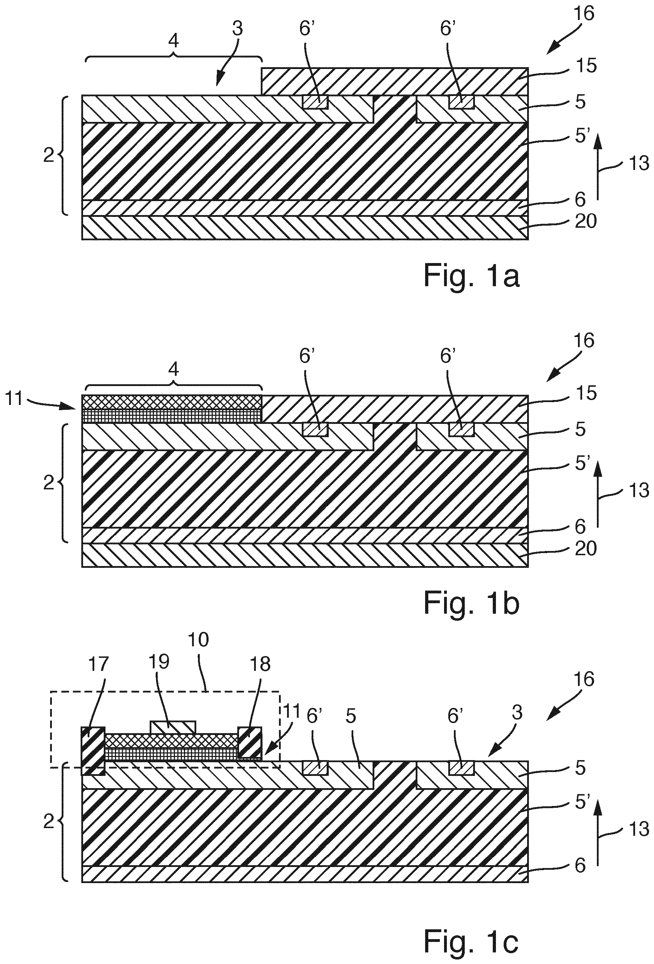

In den Figuren 1a) bis 1c) sind jeweils verschiedene Stadien bei der Durchführung des erfindungsgemäßen Verfahrens zur Herstellung eines Hochleistungsbauelementes 1 dargestellt.

Figur 1a) zeigt ein Zwischenerzeugnis 16 im Zuge der Herstellung eines Hochleistungsbauelementes 1 nach dem Verfahrensschritt C). Zur Erzeugung des in der Figur dargestellten Zwischenerzeugnisses 16 wurde zuvor in einem Verfahrensschritt A) ein Substrat 20 aus Silizium bereitgestellt, auf welchem in einem Verfahrensschritt B) ein erstes vertikales Transistor-Bauelement 2 mittels Epitaxie auf Basis von III-Nitrid-Verbindungshalbleitern hergestellt wurde. Die Epitaxie erfolgte hierbei in einer Anlage mittels Metallorganischer Chemischer Gasphasenabscheidung (MOCVD). Alternativ können solche Strukturen auch mittels Molekularstrahlepitaxie (MBE) hergestellt werden.

Das erste Transistor-Bauelement 2 umfasst eine auf dem Substrat 20 ausgebildete Kontaktschicht 6 sowie mehrere Schichten 5, 5', welche im Wesentlichen vollflächig auf der Kontaktschicht 6 erzeugt wurden. Die oberste Schicht 5 des ersten Transistor-Bauelementes 2 und somit im Wesentlichen die Oberfläche 3 des ersten Transistor-Bauelementes 2 bildend ist hierbei als p-typ dotiertes GaN ausgebildet. Die weitere Schicht 5' dient als Drift-Zone und besteht aus n-typ dotiertem GaN. Des Weiteren wurden innerhalb der obersten Schicht 5 Kontaktflächen 6' aus n-typ dotiertem GaN ausgebildet, welche zur Kontaktierung von Source und Gate des ersten Transistor-Bauelementes 2 ausgebildet sind. Das Prozessieren des ersten Transistor-Bauelementes 2 ist hierbei soweit abgeschlossen, dass lediglich entsprechende Kontakte an Source, Drain und Gate noch nicht vollständig ausgebildet sind. Strukturell ist somit das erste Transistor-Bauelement 2 in seinem Aufbau bis auf die Kontakte vollständig prozessiert.

Im Zuge der Herstellung eine Hochleistungsbauelementes 1 wurde auf die Oberfläche 3 des ersten, vertikalen Transistor-Bauelementes 2 in einem Verfahrensschritt C) eine Schutzschicht 15 in Form eines Dielektrikums, vorliegenden Siliziumoxid, aufgebracht. Die Schutzschicht 15 bedeckt hierbei nicht die gesamte Oberfläche 3 des ersten Transistor-Bauelementes 2, sondern wurde lediglich selektiv auf die Oberfläche 3 aufgebracht, wobei ein Teilbereich 4 ausgespart wird.

In einem Verfahrensschritt D) wird dann auf dem Teilbereich 4 eine laterale Heterostruktur 11 ebenfalls auf Basis von III-Nitrid-Verbindungshalbleitern monolithisch in Zuge eines Überwachsens mittels MOCVD oder eines anderen epitaktischen Wachstumsverfahrens aufgebracht. Die laterale Heterostruktur 11 umfasst hierbei ebenfalls mehrere Schichten, wobei diese Schichten so ausgebildet sind, dass sich ein zweidimensionales Elektronengases 12 in der lateralen Heterostruktur 11 ausbildet. Der Teilbereich 4 dient somit als Substrat zur Ausbildung der lateralen Heterostruktur 11. Die laterale Heterostruktur 11 weist unter anderem folgenden Aufbau auf: Auf der Oberfläche 3 des Teilbereichs 4 ist eine Barriere auf Basis eines III-Nitrids ausgebildet, wobei die Barriere aus einer Verbindung mit größerer Bandlücke besteht, als das darunterliegende III-Nitrid. Zusätzlich sind Passivierungsschichten aufgebracht, insbesondere Siliziumnitrid (SiN) oder andere nitridische Verbindung ohne elektrische Leitfähigkeit.

Im Gegensatz zur Ausbildung von CAVETS wird das zweite Bauelement 10 nur auf einer Teilfläche 4 des ersten vertikalen Transistor-Bauelementes 2 ausgebildet. Es erfolgt somit gerade kein vollflächiges Überwachsen des ersten vertikalen Transistor-Bauelementes 2. Durch das monolithische Ausbilden der lateralen Heterostruktur 11 auf der Teilfläche 4 wird insgesamt die Qualität des resultierenden Hochleistungsbauelementes 1 verbessert, da parasitäre, kapazitive und induktive Effekte beim zweiten Bauelement 10 reduziert werden. Dies führt einerseits zu einer höheren Effizienz und andererseits auch zu einer höheren Flächeneffizienz, da das erfindungsgemäße Hochleistungsbauelement 1 gegenüber dem aus dem Stand der Technik bekannten Wafer-Bonding deutlich kleiner ausgebildet werden kann.

Nach dem Überwachsen zur Erzeugung der lateralen Heterostruktur 11 auf dem Teilbereich 4 des ersten Transistor-Bauelementes 2 liegt weiter ein Zwischenerzeugnis 16 vor, wie dies in Figur 1b) dargestellt ist. Beim Überwachsen kann die laterale Heterostruktur 11 auch über eine Dicke der Schutzschicht 15 in Dickenrichtung 13 hinausgehend ausgebildet werden, wobei sich auf der Schutzschicht 15 bei der Epitaxie mittels MOCVD gerade kein Wachstum erfolgt.

Im Anschluss an das Ausbilden der lateralen Heterostruktur 11 erfolgt das Prozessieren der Heterostruktur 11 in einem Verfahrensschritt F) zu einem zweiten Bauelement 10, wobei hierfür entsprechend zumindest ein Transistor mit entsprechendem Source-Kontakt 17, Drain-Kontakt 18 und Gate-Kontakt 19 ausbildet wird, wie dies in Figur 1c) dargestellt ist. Beim Prozessieren zum zweiten Bauelement 10 können optional auch noch weitere aktive und/oder passive Bauelemente, wie beispielsweise Dioden, Sensoren, Widerstände, Induktivitäten und/oder Kondensatoren ausgebildet werden. Durch das Prozessieren wird aus der lateralen Heterostruktur 11 vorliegend zumindest ein Transistor mit hoher Elektronenbeweglichkeit, ein sogenannter HEMT, ausgebildet. Der Source-Kontakt 17 des Transistors des zweiten Bauelementes 10 wird hierbei so ausgestaltet, dass dieser in Kontakt mit der obersten Schicht 5 des ersten-Transistor-Bauelementes 2 gebracht wird. Somit wird über das zweite Bauelement 10 eine Steuerung des ersten Transistor-Bauelementes 2 ermöglicht.

Neben dem Prozessieren der lateralen Heterostruktur 11 wurde zuvor in einem Verfahrensschritt E) die Schutzschicht 15 mittels selektiven Ätzens, vorliegend mittels KOH, entfernt, so dass die mittels der Schutzschicht 15 bedeckte Oberfläche 3 des ersten Transistor-Bauelementes 2 wieder freigelegt wurde. Nach dem Ätzen der Schutzschicht 15 werden im Zuge des Prozessierens des zweiten Bauelementes 10 auch der Source-Kontakt 7, der Gate-Kontakt 9 sowie der Source-Kontakt 8 des ersten Transistor-Bauelementes 2 ausgebildet. Hierfür wurde u. a. das Substrat 20 vollständig abgelöst, so dass der Drain-Kontakt 8 vollflächig über die Kontaktschicht 6 ausgebildet werden konnte. Das Hochleistungsbauelement 1 ist insbesondere für die Anwendung im Bereich der Elektromobilität geeignet, da durch den erfindungsgemäßen Aufbau, insbesondere durch die monolithische Integration des zweiten Bauelementes 10, hohe Stromtragfähigkeiten und niedrige Schichtwiderstände erzielt werden können, wodurch eine weitaus höhere Effizienz und Leistungsdichte gegenüber der gewöhnlichen lateralen GaN-Technologie erzielt wird.

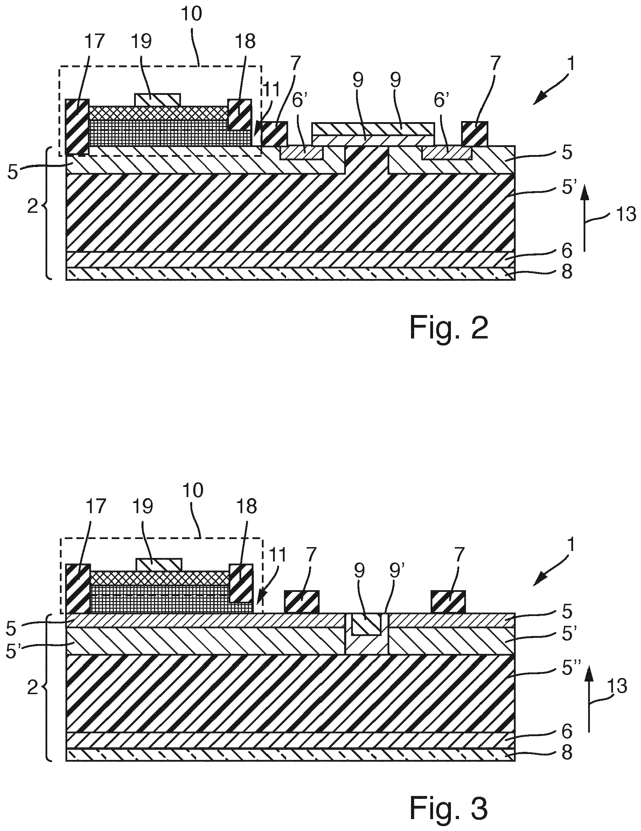

In den folgenden Figuren 2 bis 5 sind verschiedene Ausführungsformen von erfindungsgemäßen Hochleistungsbauelementen 1 dargestellt.

Figur 2 zeigt ein Hochleistungsbauelement 1 aus einem ersten Transistor-Bauelement 2 in Form eines DMOS und einem zweiten Bauelement 10 umfassend zumindest einen durch Überwachsen auf dem Teilbereich 4 der Oberfläche 3 des ersten Transistor-Bauelementes 2 ausgebildeten HEMT. Der Aufbau des ersten Transistor-Bauelementes 2 wie auch des zweiten Bauelementes 10 entstammt im Wesentlichen dem in den Figuren 1a) bis 1c) beschriebenen und dargestellten Herstellungsprozess, wobei das erste Transistor-Bauelemente 2 als auch das zweite Bauelement 10 auf Basis der Gruppe-III-Nitrid-Verbindungshalbleiter ausgebildet sind. Innerhalb des zweiten Bauelementes 10 wird durch die laterale Heterostruktur 11 ein zweidimensionales Elektronengas 12 ausgebildet, wodurch eine sehr genaue und zuverlässige Steuerung des zweiten Bauelementes 10 auch bei hohen Frequenzen im Giga-Hertz Bereich ermöglicht wird. Über den Source-Kontakt 17 und den Drain-Kontakt 18 erfolgt eine Kontaktierung des zweidimensionalen Elektronengases 12. Zudem ist der Source-Kontakt 17 des Transistor des zweiten Bauelementes 10 bis in die oberste Schicht 5 des ersten Transistor-Bauelementes 2, wiederum als p-typ dotierte Schicht 5 ausgebildet, hineinragend ausgebildet. Somit kann über das zweite Bauelement 10 auch das erste Transistor-Bauelement 2 in seinen Eigenschaften beeinflusst und gesteuert werden. Die Source-Kontakte 7 sind als ohmsche Kontakte ausgebildet. Zwischen dem Gate-Kontakt 9 und der Oberfläche 3 des ersten Transistor-Bauelementes 2 ist ein Gate-Isolator 9`, beispielsweise aus Siliziumnitrid oder Aluminiumoxid, ausgebildet. Die Sperrfestigkeit dieses Hochleistungsbauelementes 1 ist besonders hoch und liegt bei über 1 kV. Diese Form des Hochleistungsbauelementes 1 mit einem DMOS als erstes Transistor-Bauelement 2 eignet sich insbesondere als Hochvoltwandler und wird beispielsweise im Bereich Automotive eingesetzt.

In Figur 3 ist eine weitere Ausführungsform des erfindungsgemäßen Hochleistungsbauelementes 1 dargestellt, bei welcher das erste, vertikale Transistor-Bauelement 2 in Form eines MOSFET vorliegt. Hierbei wird die Oberfläche 3 des MOSFET als erstes Transistor-Bauelement 2 durch eine n-typ dotierte Schicht 5 gebildet, auf der auf einem Teilbereich 4 wiederum ein zweites Bauelement 10 zumindest einen HEMT umfassend ausgebildet wurde. Unterhalb der obersten Schicht 5 des ersten Transistor-Bauelementes 2 ist eine p-typ dotierte Schicht als Stromsperr-Schicht 5' ausgebildet. Der Source-Kontakt 17 des Transistors des zweiten Bauelementes 10 ist in diesem Falle nur bis zur Oberfläche 3 des ersten Transistor-Bauelementes 2 und somit bis zur Schicht 5 ausgebildet. Der Gate-Kontakt 9 des ersten Transistors-Bauelementes 2 ist in einem Gate-Isolator 9' eingebettet, welcher innerhalb der Schicht 5 ausgebildet ist. Diese Form des Hochleistungsbauelementes 1 mit einem MOSFET als erstes Transistor-Bauelement 2 eignet sich auch insbesondere als Hochvoltwandler und wird beispielsweise im Bereich Automotive eingesetzt.

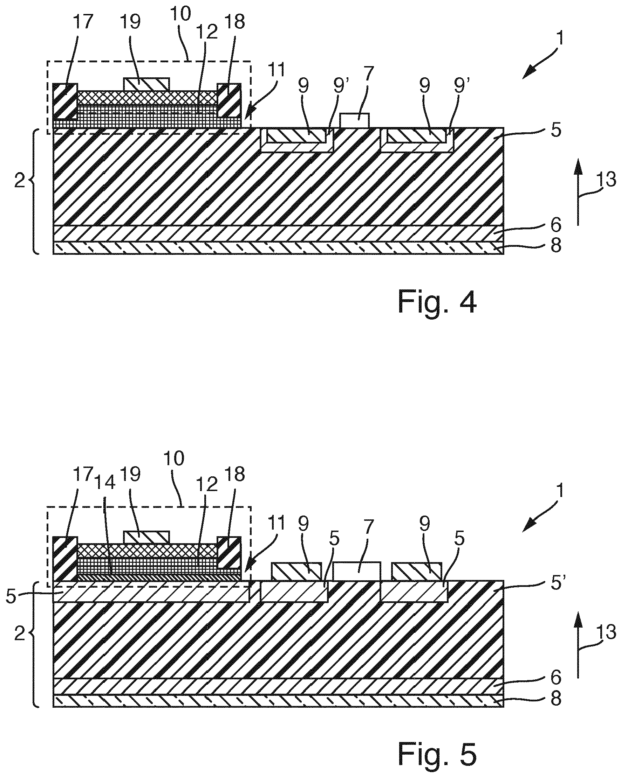

In Figur 4 ist eine nochmals weitere Form des Hochleistungsbauelementes 1 dargestellt. Gegenüber den vorstehenden Ausführungsformen des Hochleistungsbauelementes 1 unterscheidet sich diese Form im Wesentlichen in der Ausgestaltung des ersten Transistor-Bauelementes 2, welches als FinFET ausgebildet ist. Das zweite Bauelement 10 ist wiederum als einen HEMT umfassend ausgebildet, wobei der Source-Kontakt 17 und der Drain-Kontakt 18 nur in direktem Kontakt mit der lateralen Heterostruktur 11 stehen und einen Kontakt zum zweidimensionalen Elektronengas 12 ausbilden. Diese Form des Hochleistungsbauelementes 1 mit einem FinFET als erstes Transistor-Bauelement 2 eignet sich insbesondere auch als Hochvoltwandler und wird beispielsweise im Bereich Automotive eingesetzt.

In Figur 5 ist eine nochmals weitere Form des Hochleistungsbauelementes 1 dargestellt. Gegenüber den vorstehenden Ausführungsformen des Hochleistungsbauelementes 1 unterscheidet sich diese Form im Wesentlichen in der Ausgestaltung des ersten Transistor-Bauelementes 2, welches vorliegend als JFET ausgebildet ist. Das zweite Bauelement 10 ist wiederum als einen HEMT umfassend ausgebildet, wobei der Source-Kontakt 17 in Kontakt mit der Oberfläche 3 und somit der obersten Schicht 5 des ersten Transistor-Bauelementes 2 steht. Der Drain-Kontakt 18 steht nur in Kontakt mit der lateralen Heterostruktur 11 und ermöglicht zusammen mit dem Source-Kontakt 18 eine Kontaktierung des zweidimensionalen Elektronengases 12. Die oberste Schicht 5 des ersten Transistor-Bauelementes 2, welche wiederum als p-typ dotierte Schicht 5 ausgebildet ist, ist nur abschnittsweise ausgebildet. Die Bereiche der p-typ dotierten obersten Schicht 5 sind im Wesentlichen unterhalb der lateralen Heterostruktur 11 des zweiten Bauelementes 10 sowie unterhalb der Gate-Kontakte 9 angeordnet. Zudem ist auf der Oberfläche 3 des Teilbereichs 4 des ersten Transistor-Bauelementes 2 und somit unterhalb der lateralen Hetero-Struktur 11 eine Diffusionssperre 14 ausgebildet. Diese Form des Hochleistungsbauelementes 1 mit einem JFET als erstes Transistor-Bauelement 2 eignet sich insbesondere auch als Hochvoltwandler und wird beispielsweise im Bereich Automotive eingesetzt.

### Bezugszeichenliste

- 1: Hochleistungsbauelement
- 2: erstes Transistor-Bauelement
- 3: Oberfläche
- 4: Teilbereich
- 5, 5': Schicht
- 6: Kontaktschicht
- 6': Kontaktfläche
- 7: Source-Kontakt
- 8: Drain-Kontakt
- 9: Gate-Kontakt
- 9': Gate-Isolator
- 10: zweites Bauelement
- 11: Heterostruktur
- 12: Elektronengas
- 13: Dickenrichtung
- 14: Diffusionssperre
- 15: Schutzschicht
- 16: Zwischenerzeugnis
- 17: Source-Kontakt
- 18: Drain-Kontakt
- 19: Gate-Kontakt
- 20: Substrat

## Patentansprüche

1. Hochleistungsbauelement (1) auf Basis von III-Nitrid-Verbindungshalbleitern, umfassend zumindest ein erstes, vertikales Transistor-Bauelement (2) und zumindest ein zweites Bauelement (10) mit einer lateralen Heterostruktur (11), wobei die laterale Heterostruktur (11) des zweiten Bauelements (10) auf einem Teilbereich (4) einer Oberfläche (3) des ersten, vertikalen Bauelementes (2) monolithisch mittels selektivem epitaktischem Überwachsens ausgebildet ist, wobei das zweite Bauelement (10) zumindest einen Transistor und optional zumindest ein weiteres aktives und/oder passives Bauelement umfasst und wobei
sowohl das erste Transistor-Bauelement (2) als auch das zweite Bauelement (10) auf Basis von III-Nitrid-Verbindungshalbleitern gebildet sind.

2. Hochleistungsbauelement (1) nach Anspruch 1, **dadurch gekennzeichnet, dass** innerhalb der lateralen Heterostruktur (11) des zweiten Bauelementes (10) ein zweidimensionales Elektronengas (12) ausgebildet ist und/oder. **dass** die laterale Heterostruktur (11) auf Basis von AlGaN, AIN, ScAlGaN, InAlGaN und/oder YAlGaN ausgebildet ist.

3. Hochleistungsbauelement (1) nach einem der vorhergehenden Ansprüche, **dadurch gekennzeichnet, dass** zur Ausbildung des Teilbereiches (4) auf der Oberfläche (3) des ersten Transistor-Bauelementes (2) eine Schutzschicht (15), insbesondere eine hochtemperaturstabile Schutzschicht (15), außerhalb des Teilbereiches (4) ausgebildet ist, vorzugsweise
**dass** die Schutzschicht (15) aus einem Dielektrikum gebildet ist, insbesondere aus Siliziumnitrid oder Siliziumoxid.

4. Hochleistungsbauelement (1) nach einem der vorhergehenden Ansprüche, **dadurch gekennzeichnet, dass** das Hochleistungsbauelement (1) eine Sperrfestigkeit größer 200 V, bevorzugt größer 600 V, besonders bevorzugt größer 1 kV aufweist.

5. Hochleistungsbauelement (1) nach einem der vorhergehenden Ansprüche, **dadurch gekennzeichnet, dass** das erste Bauelement (2) frei von einem polarisationsinduzierten Elektronenkanal ist und/oder
**dass** das erste Bauelement (2) mehrere Schichten (5, 5`) umfasst, wobei vorzugsweise die die Oberfläche (3) bildende oberste Schicht des ersten Bauelementes (2) n-typ oder p-typ dotiert ist.

6. Hochleistungsbauelement (1) nach einem der vorhergehenden Ansprüche, **dadurch gekennzeichnet, dass** auf dem Teilbereich (4) zwischen dem ersten Bauelement (2) und der lateralen Heterostruktur (11) des zweiten Bauelementes (10) eine Diffusionssperre (14) ausgebildet ist.

7. Hochleistungsbauelement (1) nach einem der vorhergehenden Ansprüche, **dadurch gekennzeichnet, dass** ein Source-Kontakt (17) des Transistors des zweiten Bauelementes (10) in das erste Bauelement (2), insbesondere in die oberste Schicht (5) des ersten Bauelementes (2) hineinragend ausgebildet ist.

8. Hochleistungsbauelement (1) nach einem der vorhergehenden Ansprüche, **dadurch gekennzeichnet, dass** das erste Bauelement (2) als ein MOSFET, Trench MOSFET, DMOS, JFET, FinFET, OGFET oder SIT ausgebildet ist oder ein MOSFET, Trench MOSFET, DMOS, JFET, FinFET, OGFET oder SIT umfasst und/oder
**dass** das zweite Bauelement (10) als ein HEMT ausgebildet ist oder einem HEMT umfasst, vorzugsweise dass das zweite Bauelement (10) als ein MOSHEMT oder MISHEMT ausgebildet ist oder ein MOSHEMT oder MISHEMT umfasst oder ein p-Gate, insbesondere p-GaN-Gate, oder Recess-Gate umfasst.

9. Hochleistungsbauelement (1) nach einem der vorhergehenden Ansprüche, **dadurch gekennzeichnet, dass** das zweite Bauelement (10) als Kaskaden-Schaltung für das erste Bauelement (2) verwendet wird, insbesondere dass das erste Transistor-Bauelement (2) ein selbstleitendes Verhalten und das zweite Bauelement (10) ein selbstsperrendes Verhalten aufweist und/oder **dass** das zweite Bauelement (10) als integrierter Gate-Treiber, Stromsensor und/oder Temperatursensor verwendet wird.

10. Zwischenerzeugnis (16) zur Herstellung eines Hochleistungsbauelement (1) nach einem der vorhergehenden Ansprüche, **dadurch gekennzeichnet, dass** das Zwischenerzeugnis (16) ein erstes, vertikales Transistor-Bauelement (2) und eine mittels Epitaxie monolithisch ausgebildete laterale Heterostruktur (11) auf einem Teilbereich (4) einer Oberfläche (3) des ersten, vertikalen Bauelementes (2) sowie außerhalb des Teilbereiches (4) der Oberfläche (3) des ersten, vertikalen Bauelementes (2) eine Schutzschicht (15), insbesondere eine hochtemperaturstabile Schutzschicht (15) umfasst.

11. Verfahren zur Herstellung eines Hochleistungsbauelementes (1) auf Basis von III-Nitrid-Verbindungshalbleitern, umfassend die Schritte:
A) Bereitstellen eines Substrates (20);
B) Herstellen zumindest eines ersten, vertikalen Transistor-Bauelementes (2) auf dem Substrat (20) mittels Epitaxie;
C) Selektives Beschichten einer Oberfläche (3) des ersten Bauelementes (2) mit einer Schutzschicht (15) bis auf einen Teilbereich (4);
D) Herstellen einer monolithischen lateralen Heterostruktur (11) auf dem Teilbereich (4) durch Überwachsen mittels Epitaxie;
E) Ätzen der Schutzschicht (15); und
F) Prozessieren der Heterostruktur (11) zur Ausbildung zumindest eines zweiten Bauelementes (10) mit lateraler Heterostruktur (11) auf dem Teilbereich (4) des ersten Bauelementes (2), wobei das zweite Bauelement (10) zumindest einen Transistor und optional weitere aktive und/oder passive Bauelemente umfasst.

12. Verfahren nach Anspruch 11, **dadurch gekennzeichnet, dass** das erste Bauelement (2) als ein MOSFET, Trench MOSFET, DMOS, JFET, FinFET, OGFET oder SIT ausgebildet wird und/oder das zweite Bauelement (10) als ein HEMT ausgebildet wird, vorzugsweise dass das zweite Bauelement (10) als ein MOSHEMT oder MISHEMT oder ein p-Gate, insbesondere p-GaN-Gate, oder Recess-Gate umfassend ausgebildet wird.

13. Verfahren nach einem der vorhergehenden Ansprüche 11 oder 12, **dadurch gekennzeichnet, dass** nach dem Verfahrensschritt C) und vor dem Verfahrensschritt D) auf den Teilbereich (4) eine Diffusionssperre (14) aufgebracht wird.

14. Verfahren nach einem der vorhergehenden Ansprüche 11 bis 13, **dadurch gekennzeichnet, dass** als Substrat (20) Saphir, Silizium, SiC, GaN oder eine Keramik verwendet wird und/oder **dass** die Epitaxie mittels Metallorganischer Chemischer Gasphasenabscheidung (MOCVD) oder Molekularstrahlepitaxie (MBE)erfolgt.

15. Verfahren nach einem der vorhergehenden Ansprüche 11 bis 14, **dadurch gekennzeichnet, dass** der Verfahrensschritt F) vor dem Verfahrensschritt E) erfolgt und/oder dass nach Verfahrensschritt D) oder Verfahrensschritt E) ein Zwischenerzeugnis (16) vorliegt.
